# EUROPÄISCHE PATENTANMELDUNG

(11) **EP 0 762 635 A2**
(43) Veröffentlichungstag der Anmeldung: **12.03.1997**
(21) Anmeldenummer: 96114085.2
(22) Anmeldetag: 03.09.1996
(51) Int. Cl.: H03F 3/45, H03F 3/30

(54) **Stromtreiberschaltung mit Querstromregelung**

(30) Priorität: 12.09.1995 DE 19533768
(71) Anmelder: SIEMENS AKTIENGESELLSCHAFT, 80333 München (DE)
(72) Erfinder: Punzenberger, Manfred, Dipl.-Ing., 4210 Gallneukirchen (AT)

(57) **Zusammenfassung**

Eine Stromtreiberschaltung mit Querstromregelung enthält eine CMOS-Ausgangstreiberstufe (M1, M2). Jedem Ausgangstransistor (M1, M2) ist ein gate- und sourcegekoppelter Stromabfragetransistor (M3, M4) zugeordnet. Von den durch die Stromabfragetransistoren fließenden Strömen werden Steuersignale abgeleitet, durch die ein erster Zweig eines Differenzverstärkers angesteuert wird. Dessen zweiter Zweig wird von einem Referenzsignal gesteuert. In die Ausgangskreise des Differenzverstärkers sind Eingangszweige (M15, M16) je eines Stromspiegels geschaltet, deren Ausgangszweige gate- und sourcegekoppelte Transistoren (M5, M6) zum Anschluß eines Eingangssignals (Vin) enthalten. Die Mittelabgriffe der Ausgangszweige dieser Stromspiegel dienen zur Ansteuerung je eines der Ausgangstransistoren (M1, M2). Die Stromtreiberschaltung weist einen hohen Ausgangsspannungshub bei geringflächigen Ausgangstransistoren (M1, M2) auf und kann mit niedriger Versorgungsspannung betrieben werden.

## Beschreibung

Die Erfindung betrifft eine Stromtreiberschaltung mit Querstromregelung, die mindestens zwei zwischen Anschlüsse für eine Versorgungsspannung in Reihe geschaltete komplementäre Ausgangstransistoren enthält, an deren Verbindungsknoten ein Ausgangsanschluß angeschlossen ist.

Ein CMOS-Ausgangstreiber ist in der Literaturstelle J. A. Fisher, R. Koch, "Highly Linear CMOS Buffer Amplifier", IEEE Journal of Solid-State Circuits, Band SC-22, Nr. 3, Juni 1987, Seiten 330 bis 334 beschrieben. Da beide Ausgangstransistoren gleichzeitig leitend geschaltet sind, ist eine Regelung des Querstroms notwendig. Hierzu werden die Ausgangstransistoren über Stromspiegel angesteuert. Die Einstellung des Querstroms ist möglich, solange beide Ausgangstransistoren in Sättigung betrieben werden. Die Schaltung hat jedoch den Nachteil, daß an den Gateanschlüssen der Ausgangstransistoren nur ein geringer Spannungshub möglich ist. Für hohe Stromtreiberfähigkeit sind deshalb relativ große Ausgangstransistoren notwendig. Außerdem wird eine relativ hohe Versorgungsspannung (z. B. 5 V) benötigt.

Die Aufgabe der Erfindung besteht darin, diese Nachteile zu vermeiden. Insbesondere soll eine Stromtreiberschaltung mit Querstromregelung angegeben werden, die einen hohen Ausgangsspannungshub ermöglicht und dabei relativ kleine Ausgangstransistoren erfordert. Die Schaltung soll bei geringer Versorgungsspannung betreibbar sein.

Diese Aufgabe wird durch eine Stromtreiberschaltung nach den Merkmalen des Patentanspruchs 1 gelöst.

Bei der erfindungsgemäßen Schaltung wird die Querstromregelung relativ genau ausgeführt. Durch die Verwendung von kleinen Ausgangstransistoren wird bei der Realisierung als integrierte Schaltung Chipfläche gespart. An den Ausgangstransistoren sind relativ hohe Gate-Source-Spannungen möglich. Durch den am Ausgang erreichbaren hohen Spannungshub können die Ausgangstransistoren im Widerstandsbereich mit hoher Verstärkung arbeiten. Es sind große ohmsche und kapazitive Lasten treibbar. Der Ausgangshub reicht bis nahe an die Versorgungsspannung, so daß bei gegebenem Laststrom eine hohe Aussteuerbarkeit vorliegt. Insgesamt ist die erforderliche Versorgungsspannung relativ niedrig und liegt bei praktischen Ausführungen unterhalb von 2 V.

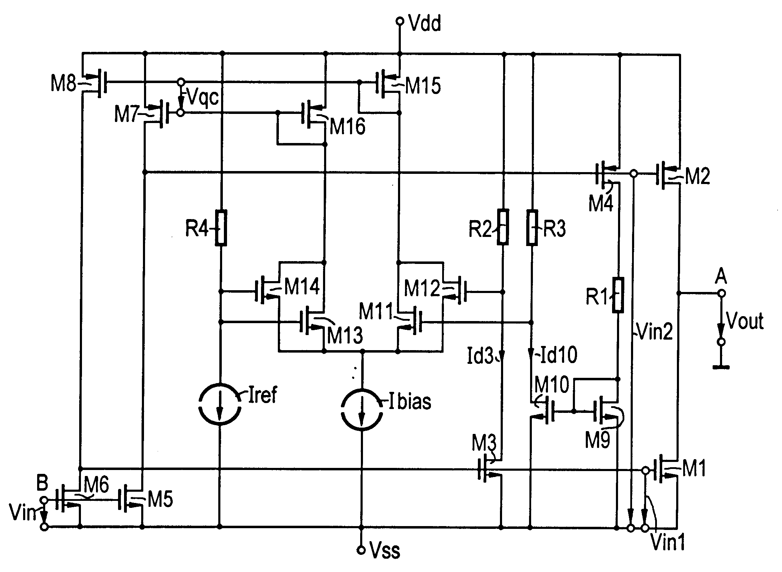

Nachfolgend wird die Erfindung anhand der in der Figur dargestellten schaltungstechnischen Realisierung näher erläutert.

Die Ausgangsstufe kann beispielsweise als Ausgangsstufe eines CMOS-Operationsverstärkers verwendet werden. Die Ausgangsstufe enthält zwei komplementäre MOS-Transistoren M1, M2. Der Sourceanschluß des n-Kanal-MOS-Transistors M1 ist mit einem Anschluß für das Versorgungspotential Vss (z. B. Masse) verbunden. Der Sourceanschluß des p-Kanal-MOS-Transistors M2 ist mit einem Anschluß für das (positive) Versorgungspotential Vdd verbunden. Die Drainanschlüsse der Transistoren M1, M2 sind mit dem Ausgangsanschluß A verbunden, an dem die Ausgangsspannung Vout gegen Masse anliegt.

Prinzipiell wird die Ausgangsspannung Vout durch den Gleichtaktanteil Vin1 + Vin2 der an den Gateanschlüssen der Transistoren M1, M2 anliegenden Spannung eingestellt. Der Querstrom wird durch den Differenzanteil Vin2 - Vin1 der Gate-Spannungen der Transistoren M1, M2 festgelegt.

Zur Erfassung der durch die Transistoren M1, M2 jeweils fließenden Ströme ist diesen Transistoren jeweils ein Stromabfragetransistor M3 bzw. M4 zugeordnet. Der Sourceanschluß des Transistors M3 ist mit dem Anschluß für das Versorgungspotential Vss verbunden, der Gateanschluß mit dem Gateanschluß des Transistors M1. Entsprechendes gilt für den komplementären Transistor M4. Der durch den Transistor M4 fließende Strom wird zweckmäßigerweise über einen Stromspiegel M9, M10 zum Anschluß für das Versorgungspotential Vss abgeleitet. Die an die Ströme durch die Transistoren M1 bzw. M2 gekoppelten Drainströme durch die Transistoren M3 bzw. M10 (Id3, Id10) sind dadurch in gleiche Richtung orientiert, was die Auswertung erleichtert. Ein Widerstand R1 im Eingangszweig des Stromspiegels M9, M10 sorgt für eine Strombegrenzung. In die Drainstromkreise der Transistoren M3, M10 ist je ein Widerstand R2 bzw. R3 geschaltet, wodurch die Ströme Id3 bzw. Id10 in entsprechende auf das Versorgungspotential Vdd bezogene Spannungen umgesetzt werden.

Beim Anschluß einer Last an den Ausgangsanschluß A wird ein Strom aus dem Anschluß A gezogen bzw. dort eingespeist. Es befindet sich dann derjenige Ausgangstransistor M1 oder M2 in Sättigung, durch den der geringere Strom fließt. Da der jeweils zugeordnete Stromabfragetransistor M3 bzw. M4 die gleiche Gate-Source-Spannung aufweist wie der jeweilige Transistor M1 oder M2, stehen die einander zugeordneten Drainströme von M1 und M3 oder M2 und M4 in einem durch die Transistorgeometrie bestimmten, festen Verhältnis zueinander. Der durch den sich jeweils in Sättigung befindenden Ausgangstransistor M1 oder M2 fließende Strom stellt dann den Querstrom durch den aus den Ausgangstransistoren M1, M2 gebildeten Strompfad dar. Durch die direkte Kopplung dieses Stromes zu den Strömen Id3 bzw. Id10 sind diese Ströme ein Maß für den Querstrom durch die Ausgangstransistoren M1, M2. Ebenso sind die an den Widerständen R2, R3 abfallenden Spannungen ein Maß für den Querstrom.

Die an den Widerständen R2, R3 anliegenden Spannungen werden in eine Differenzverstärkeranordnung eingespeist. Hierzu ist der Kopplungsknoten zwischen Widerstand R2 und Transistor M3 mit dem Gateanschluß eines Transistors M12 verbunden. Der Kopplungsknoten zwischen dem Widerstand R3 und dem Transistor M10 ist mit dem Gateanschluß eines MOS-Transistor M11 verbunden. Die MOS-Transistoren M11, M12 sind bezüglich ihres Drain-Source-Strompfads parallel geschaltet. Der andere Zweig der Differenzverstärkeranordnung enthält mit ihren Drain-Source-Strecken parallel geschaltete MOS-Transistor M13, M14, deren Gateanschlüsse von einem Referenzpotential gesteuert werden. Die Sourceanschlüsse der Transistoren M11...M14 sind miteinander gekoppelt und über eine Stromquelle Ibias zum Anschluß für das Versorgungspotential Vss geschaltet. Das Referenzspannungssignal wird von einem Widerstand R4 abgeleitet, dessen ersten Anschluß an den Anschluß für das Versorgungspotential Vdd geschaltet ist und dessen zweiten Anschluß über eine Referenzstromquelle Iref an den Anschluß für das Versorgungspotential Vss geschaltet ist.

In die gekoppelten Drainkreise der Transistoren M11, M12 bzw. M13, M14 der beiden Zweige der Differenzverstärkeranordnung ist je ein Eingangszweig einer Stromspiegelschaltung geschaltet, deren Bezugsknoten der Anschluß für das Versorgungspotential Vdd ist. Hierzu sind die Drainanschlüsse der Transistoren M11, M12 über die Drain-Source-Strecke eines MOS-Transistors M15 mit dem Anschluß für das Versorgungspotential Vdd verbunden, wobei Gate- und Drainelektrode des Transistors M15 miteinander verbunden sind. In entsprechender Weise verbindet ein Transistor M16 die Drainanschlüsse der Transistoren M13, M14 zum Versorgungspotential Vdd hin. In den Ausgangszweigen dieser Stromspiegel liegt ein gesteuerter Transistor M8 bzw. M7, wobei die Gateanschlüsse der Transistoren M8, M15 und der Transistoren M7, M16 miteinander verbunden sind. Die Drainanschlüsse der Transistoren M7, M8 sind über die Drain-Source-Strecke je eines Transistors M5 bzw. M6 mit dem Anschluß für das Massepotential Vss verbunden. Die Gate-Elektroden der Transistoren M5, M6 sind miteinander zum Anschluß B für das Eingangssignal Vin gekoppelt. Der Kopplungsknoten der Drainanschlüsse der Transistoren M6, M8 dient zur Ansteuerung des Gateanschlusses des Transistors M1, und der Kopplungsknoten der Drainanschlüsse der Transistoren M5, M7 dient zur Ansteuerung des Gateanschlusses des Transistors M2. Durch die Eingangsspannung Vin an den Eingangstransistoren M5, M6 wird hierbei die Ausgangsspannung Vout eingestellt, durch die Spannungsdifferenz Vqc zwischen den Gateanschlüssen der Transistoren M8, M7 wird der Querstrom durch die Ausgangstransistoren M1, M2 eingestellt.

Wenn der Ausgangstreiber ohne Laststrom am Anschluß A betrieben wird, fließt der Ruhestrom durch die Ausgangstransistoren M1, M2. Die Ströme Id3 und Id10 sind gleich groß, so daß die Transistoren M11, M12 (gleiche Widerstände R2, R3 vorausgesetzt) vom gleichen Potential angesteuert werden. Die durch die beiden Zweige des Differenzverstärkers fließenden Ströme werden über die Transistoren M15 bzw. M16 in die Eingangsstrompfade mit den Transistoren M7 bzw. M8 gespiegelt, durch die wiederum die Gateanschlüsse der Transistoren M2 bzw. M1 angesteuert werden, wodurch mittel der Spannung Vqc der Querstrom geregelt wird.

Wenn einer der beiden Ausgangstransistoren M1 oder M2 zusätzlich einen Laststrom führt, tritt der andere der Ausgangstransistoren M2 bzw. M1 in Sättigung. Der zugeordnete Strom Id10 bzw. Id3 ist - wie oben beschrieben - ein Maß für den jeweiligen Querstrom. Dieser kleinere der Ströme Id10 oder Id3 verursacht am entsprechenden Widerstand R3 bzw. R2 den geringeren Spannungsabfall, so daß der von diesem Widerstand angesteuerte Transistoren M1 oder M12 leitend bleibt, während der andere dieser Transistoren gesperrt ist. Dies hat zur Folge, daß durch denjenigen Transistor M11, M12, der leitendend ist, der doppelte Strom fließt. Dadurch ist seine Gate-Source-Spannung geringfügig größer als im Fall ohne ausgangsseitigen Laststrom. Auch wird dadurch die Gate-Source-Spannung der Referenztransistoren M13, M14 aufgrund der Sourcekopplung mit den Transistoren M11, M12 um diesen Betrag erhöht, so daß über den Transistor M16 die Spannung Vqc vergrößert wird. Dies wiederum hat zur Folge, daß der Querstrom durch den sich in Sättigung befindenden Ausgangstransistor M2 oder M1 geringfügig höher eingestellt wird. In der praktischen Ausführung ergibt sich ein um etwa 5 bis 10% höherer Querstrom als bei nicht belastetem Ausgang A.

Durch die Miller-Kapazitäten zwischen den Drain-Gate-Strecken der Transistoren M1, M2 wird der Signalpfad in vorteilhafter Weise stabilisiert. Außerdem kann die Querstromregelung durch Kapazitäten zwischen den Gateanschlüssen der Transistoren M1 und M2 zu den jeweiligen Versorgungspotentialen Vss bzw. Vdd stabilisiert werden. Diese können bei hinreichend großflächigen Ausgangstransistoren M1, M2 und relativ großen Miller-Kapazitäten entfallen. Darüber hinaus wird die Eingangsspannung Vin von einer Differenzeingangsstufe abgeleitet, die differentielle Eingangssignale in das Eintaktsignal Vin, das auf Massepotential Vss bezogen ist, umsetzt. In der praktischen Ausführung können außerdem die Widerstände wie R1, R2, R3, R4 als diodengekoppelte MOS-Transistoren ausgeführt werden, bei denen Gate- und Drainanschlüsse miteinander verbunden sind. Diese Realisierung ist einfach integrierbar, da nur Transistorbauelemente verwendet werden.

## Patentansprüche

1. Stromtreiberschaltung mit Querstromregelung, enthaltend:
- mindestens zwei komplementäre Ausgangstransistoren (M1, M2), deren Hauptstrompfade in Reihe zwischen Anschlüsse für eine Versorgungsspannung (Vss, Vdd) geschaltet sind und mit deren Verbindungsknoten ein Ausgangsanschluß (A) verbunden ist,
- je einen mit den Ausgangstransistoren (M1, M2) gate- und sourcegekoppelten Stromabfragetransistor (M3, M4),
- ein Differenzverstärkermittel (M11...M14, Ibias), dessen einer Zweig von von den Stromabfragetransistoren (M3, M4) abgeleiteten Signalen gesteuert wird und dessen anderer Zweig von einem Referenzsignal gesteuert wird,
- einen ersten und einen zweiten Strompfad (M6, M8; M5, M7), in die je einer der Zweige des Differenzverstärkermittels mittels eines Stromspiegels eingekoppelt ist, die jeweils einen Eingangsstransistor (M6, M5) enthalten, die miteinander gategekoppelt sind, und durch deren Mittelabgriffe je einer der Ausgangstransistoren (M1, M2) gesteuert wird.

2. Schaltungsanordnung nach Anspruch 1,
**dadurch gekennzeichnet**, daß
das Differenzverstärkermittel im einen Zweig einen ersten und einen zweiten Transistor (M11, M12) aufweist, deren Hauptstrompfade parallel geschaltet sind und deren Gateanschlüsse von je einem der von den Stromabfragetransistoren (M3, M4) abgeleiteten Signalen gesteuert werden, und im anderen Zweig einen dritten und einen vierten Transistor (M13, M14) aufweist, deren Hauptstrompfade parallel geschaltet sind und sourceseitig mit den ersten und zweiten Transistoren gekoppelt sind und deren Gateanschlüsse von einem Referenzsignal gesteuert werden.

3. Schaltungsanordnung nach Anspruch 1 oder 2,
**dadurch gekennzeichnet**, daß
ein erster Widerstand (R2) in Reihe zu einem der Stromabfragetransistoren (M3) geschaltet ist und ein zweiter Widerstand (R3) in den Ausgangszweig eines Stromspiegels (M9, M10) geschaltet ist, dessen Eingangszweig in Reihe mit dem anderen Stromabfragetransistor (M4) liegt, und daß am Widerstand das abgeleitete Signal zur Steuerung des einen Zweigs des Differenzverstärkermittels abgegriffen wird.

4. Schaltungsanordnung nach Anspruch 3,
**dadurch gekennzeichnet**, daß
ein zwischen die Anschlüsse für die Versorgungsspannung (Vss, Vdd) geschalteter Strompfad vorgesehen ist, der die Reihenschaltung eines Widerstand (R4) mit einer Referenzstromquelle (Iref) enthält, an deren Kopplungsknoten das Referenzsignal abgegriffen wird.

5. Schaltungsanordnung nach Anspruch 3 oder 4,
**dadurch gekennzeichnet**, daß
die Widerstände (R4, R2, R3) als diodengekoppelte MOS-Transistoren ausgeführt sind.

6. Schaltungsanordnung nach einem der Ansprüche 1 bis 5,
**dadurch gekennzeichnet**, daß
im ersten Strompfad in Reihe zum Eingangstransistor (M6) ein Transistor des Ausgangszweigs (M8) eines ersten Stromspiegels geschaltet ist, dessen Eingangszweig in Reihe zu den ersten und zweiten Transistoren (M11, M12) des Differenzverstärkermittels geschaltet ist, im zweiten Strompfad in Reihe zum Eingangstransistor (M5) ein Transistor des Ausgangszweigs (M7) eines zweiten Stromspiegels geschaltet ist, dessen Eingangszweig in Reihe zu den dritten und vierten Transistoren (M13, M14) des Differenzverstärkermittels geschaltet ist, und daß der Kopplungsknoten der Transistoren (M6, M8) im ersten Strompfad mit dem Gate eines der Ausgangstransistoren (M1) verbunden ist und der Kopplungsknoten der Transistoren (M5, M7) im zweiten Strompfad mit dem Gate des anderen der Ausgangstransistoren (M2).
